(19) Europäisches Patentamt

European Patent Office

Office européen des brevets

(11) **EP 1 338 924 B1**

(12) **EUROPEAN PATENT SPECIFICATION**

(45) Date of publication and mention
of the grant of the patent:
**08.11.2006 Bulletin 2006/45**

(51) Int Cl.:
***G03F 9/00*** (2006.01)

(21) Application number: **03250891.3**

(22) Date of filing: **13.02.2003**

(54) **Alignment method and device manufacturing method**

Verfahren zur Ausrichtung und Verfahren zur Herstellung eines Artikels

Méthode d'alignement et méthode pour la fabrication d'un dispositif

(84) Designated Contracting States:
**DE FR GB IT NL**

(30) Priority: **15.02.2002 EP 02251030**

(43) Date of publication of application:
**27.08.2003 Bulletin 2003/35**

(73) Proprietor: **ASML Netherlands B.V.**
**5504 DR Veldhoven (NL)**

(72) Inventors:
• **Best, Keith**
**San Jose, CA 95132 (US)**
• **Friz, Alex**
**San Jose, CA 95132 (US)**
• **Consolini, Joe**
**San Jose, CA 95132 (US)**
• **Van Buel, Henricus Wilhelmus Maria**
**5612 EE Eindhoven (NL)**
• **Gui, Cheng-Qun**
**5685 AZ Best (NL)**

(74) Representative: **Leeming, John Gerard**
**J.A. Kemp & Co.,**
**14 South Square,**
**Gray's Inn**
**London WC1R 5JJ (GB)**

(56) References cited:
**EP-A- 1 148 390        EP-A- 1 223 469**
**US-A- 4 758 864        US-A- 5 950 093**

• **WONG ET AL.: "EXPERIMENTAL AND SIMULATION OF ALIGNMENT MARKS" SPIE OPTICAL/LASER PHOTOGRAPHY, vol. 1463, 1991, pages 315-323, XP000988982**

## Description

The present invention relates to lithographic projection apparatus comprising:

- a radiation system for providing a projection beam of radiation;
- a support structure for supporting patterning means, the patterning means serving to pattern the projection beam according to a desired pattern;
- a substrate table for holding a substrate;
- a projection system for projecting the patterned beam onto a target portion of the substrate,
- an alignment system for detecting alignment between a reference mark and an alignment mark provided on said substrate, said alignment system comprising an optical system for illuminating said alignment mark with an alignment beam.

The term "patterning means" as here employed should be broadly interpreted as referring to means that can be used to endow an incoming radiation beam with a patterned cross-section, corresponding to a pattern that is to be created in a target portion of the substrate; the term "light valve" can also be used in this context. Generally, the said pattern will correspond to a particular functional layer in a device being created in the target portion, such as an integrated circuit or other device (see below). Examples of such patterning means include:

- A mask. The concept of a mask is well known in lithography, and it includes mask types such as binary, alternating phase-shift, and attenuated phase-shift, as well as various hybrid mask types. Placement of such a mask in the radiation beam causes selective transmission (in the case of a transmissive mask) or reflection (in the case of a reflective mask) of the radiation impinging on the mask, according to the pattern on the mask. In the case of a mask, the support structure will generally be a mask table, which ensures that the mask can be held at a desired position in the incoming radiation beam, and that it can be moved relative to the beam if so desired.
- A programmable mirror array. One example of such a device is a matrix-addressable surface having a viscoelastic control layer and a reflective surface. The basic principle behind such an apparatus is that (for example) addressed areas of the reflective surface reflect incident light as diffracted light, whereas unaddressed areas reflect incident light as undiffracted light. Using an appropriate filter, the said undiffracted light can be filtered out of the reflected beam, leaving only the diffracted light behind; in this manner, the beam becomes patterned according to the addressing pattern of the matrix-addressable surface. An alternative embodiment of a programmable mirror array employs a matrix arrangement of tiny mirrors, each of which can be individually tilted about an axis by applying a suitable localized electric field, or by employing piezoelectric actuation means. Once again, the mirrors are matrix-addressable, such that addressed mirrors will reflect an incoming radiation beam in a different direction to unaddressed mirrors; in this manner, the reflected beam is patterned according to the addressing pattern of the matrix-addressable mirrors. The required matrix addressing can be performed using suitable electronic means. In both of the situations described hereabove, the patterning means can comprise one or more programmable mirror arrays. More information on mirror arrays as here referred to can be gleaned, for example, from United States Patents US 5,296,891 and US 5,523,193, and PCT patent applications WO 98/38597 and WO 98/33096. In the case of a programmable mirror array, the said support structure may be embodied as a frame or table, for example, which may be fixed or movable as required.

- A programmable LCD array. An example of such a construction is given in United States Patent US 5,229,872. As above, the support structure in this case may be embodied as a frame or table, for example, which may be fixed or movable as required.

For purposes of simplicity, the rest of this text may, at certain locations, specifically direct itself to examples involving a mask and mask table; however, the general principles discussed in such instances should be seen in the broader context of the patterning means as hereabove set forth.

Lithographic projection apparatus can be used, for example, in the manufacture of integrated circuits (ICs). In such a case, the patterning means may generate a circuit pattern corresponding to an individual layer of the IC, and this pattern can be imaged onto a target portion (*e.g.* comprising one or more dies) on a substrate (silicon wafer) that has been coated with a layer of radiation-sensitive material (resist). In general, a single wafer will contain a whole network of adjacent target portions that are successively irradiated via the projection system, one at a time. In current apparatus, employing patterning by a mask on a mask table, a distinction can be made between two different types of machine. In one type of lithographic projection apparatus, each target portion is irradiated by exposing the entire mask pattern onto the target portion in one go; such an apparatus is commonly referred to as a wafer stepper. In an alternative apparatus — commonly referred to as a step-and-scan apparatus — each target portion is irradiated by progressively scanning the mask pattern under the projection beam in a given reference direction (the "scanning" direction) while synchronously scanning the substrate table parallel or anti-parallel to this direction; since, in general, the projection system will have a magnification factor M (generally < 1), the speed V at which the substrate table is scanned will be a factor M times that at which the mask table is scanned. More information with regard to lithographic devices as here described can be gleaned, for example, from US 6,046,792.

In a manufacturing process using a lithographic projection apparatus, a pattern (e.g. in a mask) is imaged onto a substrate that is at least partially covered by a layer of radiation-sensitive material (resist). Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. This array of procedures is used as a basis to pattern an individual layer of a device, e.g. an IC. Such a patterned layer may then undergo various processes such as etching, ion-implantation (doping), metallization, oxidation, chemo-mechanical polishing, etc., all intended to finish off an individual layer. If several layers are required, then the whole procedure, or a variant thereof, will have to be repeated for each new layer. Eventually, an array of devices will be present on the substrate (wafer). These devices are then separated from one another by a technique such as dicing or sawing, whence the individual devices can be mounted on a carrier, connected to pins, etc. Further information regarding such processes can be obtained, for example, from the book "Microchip Fabrication: A Practical Guide to Semiconductor Processing", Third Edition, by Peter van Zant, McGraw Hill Publishing Co., 1997, ISBN 0-07-067250-4.

For the sake of simplicity, the projection system may hereinafter be referred to as the "lens"; however, this term should be broadly interpreted as encompassing various types of projection system, including refractive optics, reflective optics, and catadioptric systems, for example. The radiation system may also include components operating according to any of these design types for directing, shaping or controlling the projection beam of radiation, and such components may also be referred to below, collectively or singularly, as a "lens". Further, the lithographic apparatus may be of a type having two or more substrate tables (and/or two or more mask tables). In such "multiple stage" devices the additional tables may be used in parallel, or preparatory steps may be carried out on one or more tables while one or more other tables are being used for exposures. Dual stage lithographic apparatus are described, for example, in US 5,969,441 and WO 98/40791.

In manufacture of a device using the lithographic process, it is generally necessary to perform a large number of exposures on a single substrate to create the numerous layers required to form a device. In this process it is essential that the subsequent exposures are correctly positioned relative to the previously-performed exposures. Deviations from correct alignment between layers are referred to as overlay errors. To avoid overlay errors, prior to an exposure the substrate must be correctly aligned in the lithographic apparatus. Two types of alignment tool are known. A known through-the-lens (TTL) type of alignment device illuminates alignment markers provided on the substrate in the form of gratings with laser light. The diffracted light is collected by the projection lens of the lithographic apparatus and directed onto corresponding alignment marks, usually in the form of phase gratings, provided on the mask. A detector is placed behind the mask marker and the intensity of the radiation passing through the mask marker is monitored as the wafer is scanned underneath the projection lens. A maximum in the output from the detector indicates the correct aligned position. The correct aligned position effectively provides a zero-reference for an interferometric displacement measuring device which is used to control subsequent movement of the stage. In a known off-axis type alignment device, an alignment tool at a measuring station is used to measure the positional relationship between a plurality of alignment markers provided on the substrate and one or more reference markers fixedly mounted to the substrate stage. When the substrate stage, carrying the substrate is transferred to the exposure station, the fixed reference marker provided on the substrate stage is aligned to a marker in the mask and thereby the positional relationship between the mask image and the substrate can be derived.

The known alignment tools and processes function adequately for production of semiconductor devices where the vertical difference between layers is not too large. However, the known alignment tools and techniques are not capable of performing alignments to alignment marks with large vertical separations so that to align later process layers to zero marks etched into the bare substrate, it has been necessary to form a series of alignments between alignment markers at intermediate vertical positions. This has the disadvantage that measurement errors may accumulate in the course of carrying out several alignment steps. Further problems arise in the manufacture of micro electromechanical systems (MEMS) and micro-opto-electromechanical systems (MOEMS) in which layer thicknesses are considerably greater than in the manufacture of semiconductor devices. With large layer thicknesses as occur in the manufacture of MEMS and MOEMS, it may not be possible to perform an alignment between vertically separated alignment markers using intermediate markers.

It is an object of the present invention to provide an alignment process in a lithographic apparatus having an alignment tool capable of performing an alignment between markers having a large vertical separation.

This can be achieved by the optical system being adapted to direct said alignment beam so as to be substantially normal to said substrate on said alignment mark.

By ensuring the alignment beam is normally incident on the alignment mark, a correct alignment reading can be obtained at any vertical position allowing direct alignment between marks in layers having a large vertical separation, e.g. greater than 10$\mu$m. By ensuring that the angle of incidence of the alignment beam is <0.5 mrad, alignment over vertical separations up to 300-500 $\mu$m, for example, can be achieved. With additional linear or quadratic corrections, or an angle if incidence of the alignment beam <0.25 mrad, alignment over vertical separations up to 700$\mu$m or even 1mm can be achieved.

The present invention provides a method of alignment to first and second alignment marks provided on respective first and second layers in a device formed on a substrate, said first and second layers having a large separation in the direction normal to said substrate, and said second layer having been formed after said first layer, the method comprising the steps of:

deep trench etching layers of said device covering said first layer to reveal said first alignment mark; performing an alignment to said first alignment mark using an alignment system that illuminates said first alignment mark with an alignment beam that is substantially normal to said substrate; performing an alignment to said second alignment mark using said alignment system.

According to a further aspect of the invention there is provided a device manufacturing method comprising the steps of:

- providing a substrate that is at least partially covered by a layer of radiation-sensitive material;
- providing a projection beam of radiation using a radiation system;
- using patterning means to endow the projection beam with a pattern in its cross-section;
- projecting the patterned beam of radiation onto a target portion of the layer of radiation-sensitive material,

wherein prior to said step of projecting, an alignment process according to the method described above is carried out

Although specific reference may be made in this text to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid-crystal display panels, thin-film magnetic heads, micro electro-mechanical systems (MEMS), micro opto-electro-mechanical systems (MOEMS), gene chips, etc. The skilled artisan will appreciate that, in the context of such alternative applications, any use of the terms "reticle", "wafer" or "die" in this text should be considered as being replaced by the more general terms "mask", "substrate" and "target portion", respectively.

In the present document, the terms "radiation" and "beam" are used to encompass all types of electromagnetic radiation, including ultraviolet radiation (e.g. with a wavelength of 365, 248, 193, 157 or 126 nm) and EUV (extreme ultra-violet radiation, e.g. having a wavelength in the range 5-20 nm), as well as particle beams, such as ion beams or electron beams.

Embodiments of the invention will now be described, by way of example only, with reference to the accompanying schematic drawings in which:

Figure 1 depicts a lithographic projection apparatus usable in the invention;
Figure 2 is a simplified diagram of the alignment system included in the lithographic projection apparatus of Figure 1;
Figure 3 illustrates three steps in the alignment process;
Figure 4 illustrates the origin of telecentricity errors in a non-telecentric alignment tool;
Figure 5 illustrates high-level and recessed alignment marks which are aligned to in the method according to the present invention; and
Figure 6 illustrates the effect of telecentricity errors in a non-telecentric alignment tool.

In the Figures, corresponding reference symbols indicate corresponding parts.

Embodiment 1

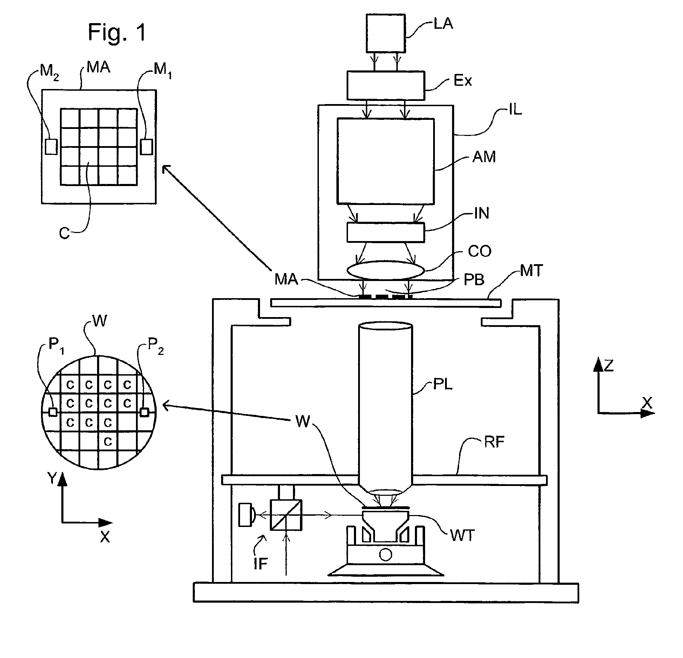

Figure 1 schematically depicts a lithographic projection apparatus usable for carrying out the method of the invention. The apparatus comprises:

a radiation system Ex, IL, for supplying a projection beam PB of radiation (e.g. UV radiation), which in this particular case also comprises a radiation source LA;
a first object table (mask table) MT provided with a mask holder for holding a mask MA (e.g. a reticle), and connected to first positioning means for accurately positioning the mask with respect to item PL;
a second object table (substrate table) WT provided with a substrate holder for holding a substrate W (e.g. a resist-coated silicon wafer), and connected to second positioning means for accurately positioning the substrate with respect to item PL;
a projection system ("lens") PL (e.g. a refractive lens system) for imaging an irradiated portion of the mask MA onto a target portion C (e.g. comprising one or more dies) of the substrate W.

As here depicted, the apparatus is of a transmissive type (e.g. has a transmissive mask). However, in general, it may also be of a reflective type, for example (e.g. with a reflective mask). Alternatively, the apparatus may employ another kind of patterning means, such as a programmable mirror array of a type as referred to above.
The source LA (e.g. an Hg lamp) produces a beam of radiation. This beam is fed into an illumination system (illuminator) IL, either directly or after having traversed conditioning means, such as a beam expander Ex, for example. The illuminator IL may comprise adjusting means AM for setting the outer and/or inner radial extent (commonly referred to as σ-outer and σ-inner, respectively) of the intensity distribution in the beam. In addition, it will generally comprise various other components, such as an integrator IN and a condenser CO. In this way, the beam PB impinging on the mask MA has a desired uniformity and intensity distribution in its cross-section.

It should be noted with regard to Figure 1 that the source LA may be within the housing of the lithographic projection apparatus (as is often the case when the source LA is a mercury lamp, for example), but that it may also be remote from the lithographic projection apparatus, the radiation beam which it produces being led into the apparatus (e.g. with the aid of suitable directing mirrors); this latter scenario is often the case when the source LA is an excimer laser. The current invention and Claims encompass both of these scenarios.

The beam PB subsequently intercepts the mask MA, which is held on a mask table MT. Having traversed the mask MA, the beam PB passes through the lens PL, which focuses the beam PB onto a target portion C of the substrate W. With the aid of the second positioning means (and interferometric measuring means IF), the substrate table WT can be moved accurately, *e.g.* so as to position different target portions C in the path of the beam PB. Similarly, the first positioning means can be used to accurately position the mask MA with respect to the path of the beam PB, *e.g.* after mechanical retrieval of the mask MA from a mask library, or during a scan. In general, movement of the object tables MT, WT will be realized with the aid of a long-stroke module (course positioning) and a short-stroke module (fine positioning), which are not explicitly depicted in Figure 1. However, in the case of a wafer stepper (as opposed to a step-and-scan apparatus) the mask table MT may just be connected to a short stroke actuator, or may be fixed.

The depicted apparatus can be used in two different modes:

> 1. In step mode, the mask table MT is kept essentially stationary, and an entire mask image is projected in one go (*i.e.* a single "flash") onto a target portion C. The substrate table WT is then shifted in the x and/or y directions so that a different target portion C can be irradiated by the beam PB;
> 2. In scan mode, essentially the same scenario applies, except that a given target portion C is not exposed in a single "flash". Instead, the mask table MT is movable in a given direction (the so-called "scan direction", *e.g.* the y direction) with a speed v, so that the projection beam PB is caused to scan over a mask image; concurrently, the substrate table WT is simultaneously moved in the same or opposite direction at a speed $V = Mv$, in which $M$ is the magnification of the lens PL (typically, $M = 1/4$ or $1/5$). In this manner, a relatively large target portion C can be exposed, without having to compromise on resolution.

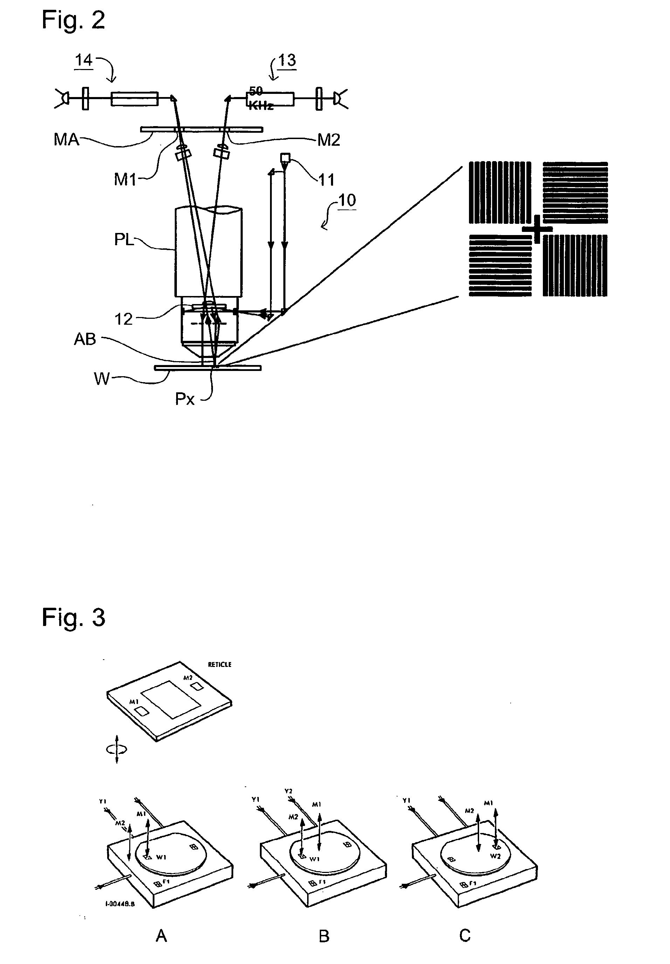

A simplified schematic of the alignment system 10 and the form of the substrate alignment mark Px is shown in Figure 2. The alignment system 10 comprises a 633nm laser whose light is projected through the projection lens onto the substrate to illuminate the substrate alignment mark Px. As shown in the enlargement, substrate alignment mark Px consists of four gratings. Two are of $16\mu$m pitch and two of $17.6\mu$m pitch with one of each type aligned with each stage coordinate axis (X, Y). The 1st-order reflected light from the substrate alignment mark Px is collected by the projection system PL and focused on to a complimentary mark Mx of similar structure on the mask. It will be appreciated that there will be multiple substrate and mask marks which may be denoted by a numeral replacing the x in Px and Mx. The interference signal created by the 1st-order reflected light from the substrate marks Px interfering with the mask marks Mx creates an interference signal that is filtered and subsequently detected in detection branches 13, 14. A special filter 12 is provided in the projection system PL to select only the 1st-order diffracted beams.

In an alignment procedure using this alignment system, the substrate is placed on the substrate table and undergoes a mechanical and optical pre-alignment on a pre-alignment unit which is not relevant to the present invention and therefore not described further herein. The pre-alignment effects only a coarse alignment and therefore a fine alignment must also be performed, the procedure for which is illustrated in Figure 3. Figure 3 shows the mask MA carrying alignment markers M1 and M2, substrate W carrying alignment markers W1 and W2 as well as the substrate table WT carrying alignment marker F1 (sometimes referred to as a fiducial). Initially, the interferometric displacement measuring system IF is zeroed by aligning the fiducial F1 to mask marks M1, M2 in the mask. Next, a total alignment process is carried out by aligning substrate mark W1 to mask marks M1 and M2 and substrate mark W2 to mask mark M1. The first two steps allow to determine the mask rotation and lens magnification. The substrate and mask are then fully aligned by aligning substrate mark W1 to mask mark M1, substrate mark W2 to mask mark M1 then substrate mark W1 to mask mark M1 and substrate mark W1 to mask mark M2. After these alignments, the substrate is exposed with no further alignments necessary.

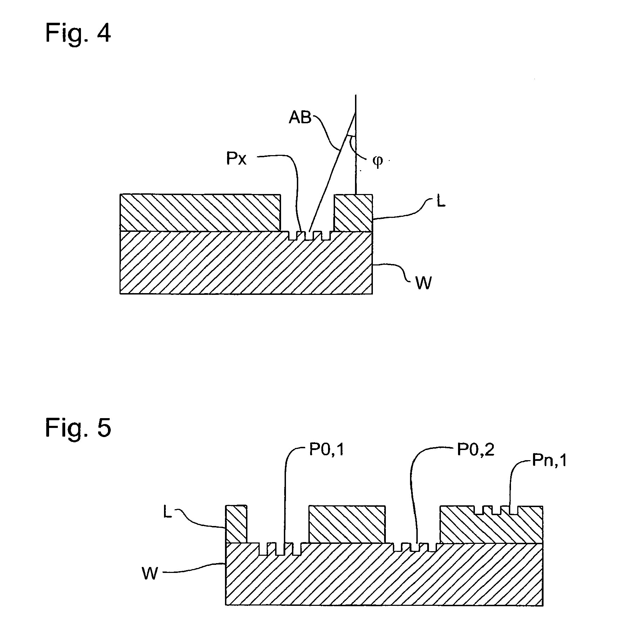

In order to enable accurate alignments to be carried out at substantially differing Z-positions, the alignment beam leaving the projection system PL is arranged to be telecentric. The effect if this requirement is not met is shown in Figure 4 where it can be seen that if the alignment beam AB, is not orthogonal to the bottom of the lens at its exit from the projection system, PL, and hence makes an angle φ to the normal to the substrate then there will be a positional error in aligning to a deeply-recessed substrate mark Px, *e.g.* provided in the substrate W beneath a trench in a subsequent process layer L. This error is proportional to sin(φ) and the depth of the alignment mark Px. Accordingly, the illumination part of the alignment system is arranged to illuminate the alignment mark Px at normal incidence, whatever the Z position of the alignment grating Px. This can be achieved by making the illumination part of the alignment system telecentric, as seen from the substrate. The illumination part of the alignment system can be made telecentric by introduction of one or more plane plates in the path of the alignment beam. The thickness, wedge angle, and orientation of the plane plate(s) are adjusted until the desired angle of incidence is achieved. Preferably, two plane plates are used, one to adjust the angle of incidence and one the X, Y offset of the alignment system. In this way, the angle of incidence of the alignment beam can be adjusted to be less than 0.5 mrad or 0.25 mrad.

As shown in Figure 5, after formation of process layer(s) L on top of substrate W, trenches are etched to reveal zero-layer marks P0,1 and P0,2 etched into the substrate W. These, and the mark Pn, 1 provided on the nth process layer, can then be aligned to by the alignment tool of the invention.

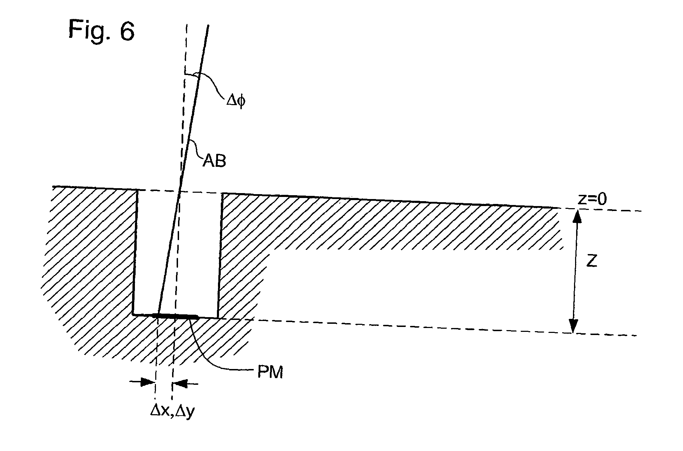

In addition to minimizing the alignment beam angle of incidence, as described above, the performance of the alignment system can be further improved by use of a software correction based on empirical data from calibration. As shown in Figure 6, an angle of incidence Δφ results in a measured position of a recessed mark PM offset from its frame position by amount Δx, Δy. Using a calibration substrate, the offsets are measured for a plurality of different vertical (Z) positions. This data is then used to determine the coefficients of a model.

A simple, linear model may take the form:

$$\Delta x = a\,z + b$$

$$\Delta y = c\,z + b.$$

Greater accuracy can be achieved using a quadratic model of the form:

$$\Delta x = a\,z^2 + c\,z + b$$

$$\Delta y = d\,z^2 + e\,z + b.$$

Where the position marker is of a type having two gratings of different period for each direction, X and Y, it may also be necessary to take into account the effect of magnification changes with vertical position in the alignment system on the apparent separation of the two gratings. This can be achieved using a model of the form:

$$\Delta \text{shift - x} = f{\cdot}Z{\cdot}\text{shift - x}$$

$$\Delta \text{shift - y} = g{\cdot}Z{\cdot}\text{shift - y}$$

where f and g are machine or machine-type dependent constants.

When the coefficients for a given machine have been determined, the alignment results are corrected using the Δx, Δy values calculated for each alignment on the basis of the vertical position of the marker.

Whilst specific embodiments of the invention have been described above, it will be appreciated that the invention may be practiced otherwise than as described. The description is not intended to limit the invention.

## Claims

1. A method of alignment to first and second alignment marks provided on respective first and second layers in a device formed on a substrate (W), said first and second layers having a large separation (2) in the direction normal to said substrate, and said second layer having been formed after said first layer, the method comprising the steps of:

   deep trench etching layers of said device covering said first layer to reveal said first alignment mark;
   performing an alignment to said first alignment mark (PM) using an alignment system that illuminates said first alignment mark with an alignment beam that is substantially normal to said substrate;
   performing an alignment to said second alignment mark using said alignment system.

2. A method according to claim 1 wherein said second marks is etched into said second layer prior to said step of deep trench etching.

3. A method according to claim 1 or 2 wherein said first and second alignment marks are diffraction gratings.

4. A method according to claim 1, 2 or 3 wherein said first layer is said substrate.

5. A method according to any one of claims 1 to 4, wherein said first layer is a layer formed above said substrate.

**6.** A method according to any one of claims 1 to 5 further comprising the step of correcting the alignments using a model of positional offsets in directions parallel to the nominal surface of said substrate as a function of the position of the alignment marker in the direction perpendicular to said nominal surface.

**7.** A method according to any one of claims 1 to 6 wherein said device is a micro electro-mechanical device or a micro opto electro-mechanical device.

**8.** A device manufacturing method comprising the steps of:

- providing a substrate that is at least partially covered by a layer of radiation-sensitive material;
- providing a projection beam of radiation using a radiation system;
- using patterning means to endow the projection beam with a pattern in its cross-section;
- projecting the patterned beam of radiation onto a target portion of the layer of radiation-sensitive material,

wherein prior to said step of projecting, an alignment process according to the method of any one of claims 1 to 7 is carried out.

**Patentansprüche**

**1.** Verfahren zum Ausrichten erster und zweiter Ausrichtmarken, die jeweils auf ersten und zweiten Schichten in einem auf einem Substrat (W) gebildeten Bauelement vorgesehen sind, wobei die ersten und zweiten Schichten einen großen Abstand (2) in senkrechter Richtung zu dem Substrat aufweisen, und wobei die zweite Schicht nach der ersten Schicht gebildet worden ist, wobei das Verfahren folgende Schritte umfasst:

Tiefschichtätzen von Schichten des Bauelements, welche die erste Schicht bedecken, um die erste Ausrichtmarke freizulegen;
Durchführen einer Ausrichtung der ersten Ausrichtmarke (PM) unter Verwendung eines Ausrichtsystems, das die erste Ausrichtmarke mit einem Ausrichtstrahl beleuchtet, der im wesentlichen senkrecht zu dem Substrat verläuft;
Durchführen einer Ausrichtung der zweiten Ausrichtmarke unter Verwendung des Ausrichtsystems.

**2.** Verfahren nach Anspruch 1, wobei die zweite Marke vor dem Schritt des Tiefenätzens in die zweite Schicht geätzt wird.

**3.** Verfahren nach Anspruch 1 oder 2, wobei die ersten und zweiten Marken Beugungsgitter sind.

**4.** Verfahren nach Anspruch 1, 2 oder 3, wobei die erste Schicht das Substrat ist.

**5.** Verfahren nach einem der Ansprüche 1 bis 4, wobei die erste Schicht eine über dem Substrat gebildete Schicht ist.

**6.** Verfahren nach einem der Ansprüche 1 bis 5, ferner umfassend den Schritt des Korrigierens der Ausrichtungen unter Verwendung eines Musters von Positionsverschiebungen in Richtungen parallel zur Nennoberfläche des Substrats als eine Funktion der Position der Ausrichtmarke in senkrechter Richtung zu der Nennoberfläche.

**7.** Verfahren nach einem der Ansprüche 1 bis 6, wobei das Bauelement ein elektromechanisches Mikro-Bauelement oder ein optischelektromechanisches Mikro-Bauelement ist.

**8.** Verfahren zur Herstellung eines Bauelements, das folgende Schritte umfasst:

- Bereitstellen eines Substrats, das zumindest teilweise mit einer Schicht aus strahlungsempfindlichem Material bedeckt ist;
- Bereitstellen eines Projektionsstrahls aus Strahlung unter Verwendung eines Strahlungssystems;
- Verwenden von Musteraufbringungseinrichtungen, um den Projektionsstrahl in seinem Querschnitt mit einem Muster zu versehen;
- Projizieren des gemusterten Strahls aus Strahlung auf einen Zielabschnitt der Schicht aus strahlungsempfindlichem Material,

wobei vor dem Schritt des Projizierens ein Ausrichtprozess gemäß dem Verfahren nach einem der Ansprüche 1 bis 7 durchgeführt wird.

**Revendications**

**1.** Procédé d'alignement par rapport à des premier et second repères d'alignement disposés sur des première et seconde couches respectives dans un dispositif formé sur un substrat (W), lesdites première et seconde couches ayant une grande séparation (2) dans la direction normale audit substrat, et ladite seconde couche ayant été formée après ladite première couche, le procédé comprenant les étapes consistant à :

graver en tranchées profondes les couches dudit dispositif couvrant ladite première couche pour révéler ledit premier repère d'alignement ; effectuer un alignement par rapport audit premier repère d'alignement (PM) en utilisant un système d'alignement qui éclaire ledit premier repère d'alignement à l'aide d'un faisceau d'alignement qui est sensiblement normal audit substrat ;
effectuer un alignement par rapport audit second repère d'alignement en utilisant ledit système d'alignement.

2. Procédé selon la revendication 1, dans lequel ledit second repère est gravé dans ladite seconde couche avant ladite étape de gravage en tranchées profondes.

3. Procédé selon la revendication 1 ou 2, dans lequel lesdits premier et second repères d'alignement sont des réseaux de diffraction.

4. Procédé selon la revendication 1, 2 ou 3, dans lequel ladite première couche est ledit substrat.

5. Procédé selon l'une quelconque des revendications 1 à 4, dans lequel ladite première couche est une couche formée au-dessus dudit substrat.

6. Procédé selon l'une quelconque des revendications 1 à 5, comprenant en outre l'étape consistant à corriger les alignements en utilisant un modèle de décalages de positions dans des directions parallèles à la surface nominale dudit substrat en fonction de la position du repère d'alignement dans la direction perpendiculaire à ladite surface nominale.

7. Procédé selon l'une quelconque des revendications 1 à 6, dans lequel ledit dispositif est un dispositif micro électro-mécanique ou un dispositif micro opto électro-mécanique.

8. Procédé de fabrication d'un dispositif comprenant les étapes consistant à :

- former un substrat qui est au moins partiellement recouvert par une couche de matériau sensible au rayonnement ;
- former un faisceau de projection de rayonnement en utilisant un système de rayonnement ;
- utiliser un moyen de formation de motif pour doter le faisceau de projection d'un motif dans sa coupe transversale ;
- projeter le faisceau formé avec un motif de rayonnement sur une portion cible de la couche de matériau sensible au rayonnement,

dans lequel avant ladite étape de projection, un procédé d'alignement selon le procédé de l'une quelconque des revendications 1 à 7 est mise en oeuvre.

# Fig. 1

## Fig. 2

## Fig. 3

A          B          C

## Fig. 4

## Fig. 5

Fig. 6